# EUROPEAN PATENT SPECIFICATION

(11) **EP 2 445 024 B1**
(45) Date of publication and mention of the grant of the patent: **07.01.2015**
(21) Application number: 09846243.5
(22) Date of filing: 05.11.2009
(51) Int. Cl.: H01L 33/64, H01L 23/495, H01L 25/075

(54) **LED ARRAY MODULE AND FABRICATION METHOD THEREOF**
LED-ARRAY-MODUL UND HERSTELLUNGSVERFAHREN DAFÜR
MODULE DE RESEAU DE DIODES ELECTROLUMINESCENTES ET SON PROCEDE DE FABRICATION

(30) Priority: 18.06.2009 KR 20090054573
(43) Date of publication of application: 25.04.2012
(73) Proprietor: Utronix Inc, Ansan-si, Gyeonggi-do 425-851 (KR)
(72) Inventor: KIM, Eunil, Anyang-si Gyeonggi-do 431-060 (KR); RYU, Woo Tae, Seoul 140-727 (KR)
(74) Representative: Viering, Jentschura & Partner Patent- und Rechtsanwälte
(86) International application number: PCT/KR2009/006496
(87) International publication number: WO 2010/147271

(56) References cited:
- EP-A1- 2 023 407
- DE-A1-102005 045 587
- KR-A- 20060 104 432
- KR-A- 20080 037 734
- KR-A- 20080 107 460
- KR-A- 20090 028 709
- US-A- 5 382 546
- US-A1- 2006 102 917
- US-A1- 2008 203 416

## Description

### BACKGROUND OF THE INVENTION

### 1. Technical Field

The present invention relates to an LED array module that radiates high-temperature heat emitted from LEDs using a radiation block by attaching LEDs to the radiation block without using a printed circuit board (PCB), wherein the radiation block includes an upper conductive layer and a lower conductive layer, and each of the conductive layers is divided into a plurality of slices to allow a plurality of LEDs to constitute a circuit in series-parallel combination, thus coping with various power requirements, and to a method of manufacturing the same.

### 2. Description of the Related Art

Conventionally, LEDs (Light Emitting Diodes) have been restrictedly used for a backlight unit of displays as a light source for LCD modules. In this case, LEDs can be used without engendering serious problems because they have a low power consumption of about 0.1 W. However, LEDs are gradually becoming widely used in illuminating lamps, street lamps, security lamps, fishing lamps and the like because of their various characteristics and advantages. Such LED-applied products require high power, so that heat is generated therefrom, thereby causing heat radiation problems. Therefore, these heat radiation problems must be overcome.

LEDs are fabricated into an LED array module and then used to obtain high power. Such an LED array module is formed by disposing a plurality of LEDs on a substrate at regular intervals.

US 2006/0102917 shows a semiconductor light emitting element is mounted on a support plate within a hole of a reflector as shown in A1.

US 2008/0203416 A1 shows a surface mounting type light emitting diode wherein a semiconductor light emitting element is mounted on a base member with a heat conduction type adhesive within a hole of a metallic reflector.

DE 10 2005 045 587 A1 shows a semiconductor light emitting device wherein a semiconductor light emitting element is mounted on a connecting structure over a compound substrate within a hole of a circuit layout layer.

US 5,382,546 shows a semiconductor device wherein a group of upper leads and lower leads are present in different planes and are separated by an insulating layer. The upper and lower leads overlap in portions and the pitch of the leads can be reduced.

EP 2 023 407 A1 shows a light element mounting substrate wherein light emitting element are mounted on a compound substrate with reflective cups within a reflective cup respectively.

Further, provided that heat radiation problems are overcome, such an LED array module can be used to exhibit higher light output by increasing electric current. Therefore, in order to obtain high efficiency, it is required to effectively radiate heat while current is flowing in addition to allowing LEDs to emit a maximum amount of light. For this reason, conventional LED array modules currently use MPCB (Metal PCB) in addition to a heat sink in order to obtain higher light output, that is, in order to improve the performance of heat radiation.

Further, in order to improve the effect of heat radiation, in addition to the use of MPCB, it is considered that LED chips are mounted on a metal board and a circuit is formed using a flexible printed circuit board (FPCB). Furthermore, in order to improve the effects of heat radiation, an attempt to form a circuit using only two metal boards was conducted, but there is a problem in that only a parallel circuit can be formed.

### SUMMARY OF THE INVENTION

Accordingly, the present invention has been devised to solve the above-mentioned problems, and an object of the present invention is to provide an LED array module that radiates high-temperature heat emitted from LEDs using a radiation block by attaching LEDs to the radiation block without using a printed circuit board (PCB), wherein the radiation block includes an upper conductive layer and a lower conductive layer, and each of the conductive layers is divided into a plurality of slices to allow a plurality of LEDs to constitute a circuit in series-parallel combination, thus coping with various power requirements, and to a method of manufacturing the same.

In order to accomplish the above object, a first aspect of the present invention provides a method of manufacturing an LED array module, including the steps of: attaching an upper conductive layer to a lower conductive layer by an insulative adhesion layer as an intermediate layer; forming an insulating layer on the entire exposed surface of the upper conductive layer and the lower conductive layer; forming a plurality of LED mounting regions by machining the upper conductive layer such that the upper surface of the lower conductive layer is exposed; mounting an LED in each of the LED mounting regions such that power is supplied to the LED by the lower conductive layer and the upper conductive layer; charging each of the LED mounting regions with a resin having insulation properties and transparency; and respectively forming upper separation grooves and lower separation grooves in the upper conductive layer and the lower conductive layer abreast in a width direction such that each of the upper conductive layer and the lower conductive layer is divided into a plurality of slices.

A second aspect of the present invention provides a method of manufacturing an LED array module, including the steps of: disposing a plurality of slices in the same plane at regular intervals to form a lower conductive layer, applying an insulative adhesion layer onto the lower conductive layer, and then disposing a plurality of slices on the insulative adhesion layer in a zigzag manner to form an upper conductive layer integrated with the lower conductive layer; forming an insulating layer over the entire exposed surface of the upper conductive layer and the lower conductive layer; forming a plurality of LED mounting regions by machining the upper conductive layer and the insulative adhesion layer such that the upper surface of the lower conductive layer is exposed by the slices of the upper conductive layer disposed on the slices of the lower conductive layer; mounting an LED in each of the LED mounting regions such that power is supplied to the LED by the lower conductive layer and the upper conductive layer; and charging each of the LED mounting regions with a resin having insulation properties and transparency.

A third aspect of the present invention provides a method of manufacturing an LED array module, including the steps of: providing a plurality of slices and a plurality of slices; disposing the plurality of slices in the same plane at regular intervals to form an upper conductive layer, disposing the plurality of slices on the upper conductive layer in zigzags such that the slices and the slices cross each other to form an upper conductive layer, and then attaching the upper conductive layer to the lower conductive layer by an insulative adhesion layer as an intermediate layer; forming a plurality of LED mounting regions by machining the upper conductive layer such that the upper surface of the lower conductive layer is exposed; mounting an LED in each of the LED mounting regions such that power is supplied to the LED by the lower conductive layer and the upper conductive layer; and charging each of the LED mounting regions with a resin having insulation properties and transparency.

Here, each of the upper conductive layer and the lower conductive layer may have a rectangular shape, and the LED mounting regions may be machined, preferably drilled, such that they are disposed in a lattice shape of one or more rows. In addition, each of the upper conductive layer and the lower conductive layer may have a disc shape, and the LED mounting regions may be machined such that they are radially disposed from the center of the upper conductive layer in the form of at least one row. Each of the upper conductive layer and the lower conductive layer may be an aluminum thin film, a metal thin film, a conductive polyester thin film or a silicon thin film. Each of the upper conductive layer and the lower conductive layer may have a thickness of 0.5 - 2.5 mm, and the upper conductive layer may be thinner than the lower conductive layer.

Further, the insulating layer may be a silicon oxide film, an aluminum oxide film or a chromium oxide film.

Further, each of the LED mounting regions may have a head-cut conical shape, and may be provided therein with a wire bonding connection part.

The method of manufacturing an LED array module according to the first, second or third aspect of the present invention may further include the step of: providing an external terminal to the upper conductive layer or the lower conductive layer by screwing or attaching such that the upper conductive layer or the lower conductive layer is externally electrically connected.

Another aspect of the present invention provides an LED array module, wherein an upper conductive layer is integrally attached to a lower conductive layer by an insulative adhesion layer as an intermediate layer, and an insulating layer is formed over the entire exposed surface of the upper conductive layer and the lower conductive layer; a plurality of LED mounting regions is formed in the upper conductive layer such that the upper surface of the lower conductive layer is exposed; an LED is mounted in each of the LED mounting regions such that power is supplied to the LED by the lower conductive layer and the upper conductive layer, and each of the LED mounting regions is charged with a resin having insulation properties and transparency; and upper separation grooves are formed in the upper conductive layer at regular intervals in a width direction every two LED mounting regions, and lower separation grooves are formed in the lower conductive layer such that each of the lower separation grooves is disposed between the two upper separation grooves.

Still another aspect of the present invention provides an LED array module, including: an upper conductive layer including a plurality of slices, each being provided with at least on pair of LED mounting regions; a lower conductive layer including a plurality of slices; an insulative adhesion layer disposed between the upper conductive layer and the lower conductive layer such that the upper conductive layer and the lower conductive layer are integrated with each other; an insulating layer formed over the entire exposed surface of the upper conductive layer and the lower conductive layer; LEDs mounted in the LED mounting regions such that they are connected with each other in series-parallel combination by the slices; and a resin having insulation properties and transparency, which is charged in each of the LED mounting regions, wherein the plurality of slices constituting the upper conductive layer and the plurality of slices constituting the lower conductive layer zigzag and cross each other at regular intervals.

Still another aspect of the present invention provides an LED array module, including: an upper conductive layer including a plurality of slices, each being provided with at least on pair of LED mounting regions; a lower conductive layer including a plurality of slices; an insulative adhesion layer disposed between the upper conductive layer and the lower conductive layer such that the upper conductive layer and the lower conductive layer are integrated with each other; LEDs mounted in the LED mounting regions such that they are connected with each other in series-parallel combination by the slices; and a resin having insulation properties and transparency, which is charged in each of the LED mounting regions, wherein the plurality of slices constituting the upper conductive layer and the plurality of slices constituting the lower conductive layer zigzag and cross each other at regular intervals.

Here, each of the upper conductive layer and the lower conductive layer has a rectangular shape or a disk shape. The LED mounting regions may be machined such that they are disposed in a lattice shape of one or more rows or such that they are radially disposed from the center of the upper conductive layer in the form of at least one row. The LED mounting regions may be drilled.

### BRIEF DESCRIPTION OF THE DRAWINGS

The above and other objects, features and advantages of the present invention will be more clearly understood from the following detailed description taken in conjunction with the accompanying drawings, in which:
FIG. 1 is a flowchart explaining a method of manufacturing an LED array module according to a first embodiment of the present invention;
FIG. 2 is a sectional view showing an upper conductive layer and a lower conductive layer, each being provided with an oxide layer depending on FIG. 1;
FIG. 3 is a sectional view showing the upper and lower conductive layers integrated with each other by an insulating layer depending on FIG. 1;
FIG. 4 is a sectional view showing an LED mounting region depending on FIG. 1;
FIG. 5 is a sectional view showing the state in which an LED is mounted in the LED mounting region;
FIG. 6 is a sectional view showing the state in which the LED mounting region is charged with a resin;
FIG. 7 is a sectional view showing the state in which the upper and lower conductive layers are divided into a plurality of slices, respectively;
FIG. 8 is a perspective view showing an LED array module manufactured by the method of manufacturing an LED array module according to the first embodiment of the present invention;
FIG. 9 is a sectional view showing an example of providing an external terminal in the method of manufacturing an LED array module according to the first embodiment of the present invention;
FIG. 10 is a circuit diagram showing the electrical connection of the LED array module manufactured by the method of manufacturing an LED array module according to the first embodiment of the present invention;
FIG. 11 is a plan view showing a modified embodiment of the LED array module manufactured by the method of manufacturing an LED array module according to the first embodiment of the present invention;
FIG. 12 is a flowchart explaining a method of manufacturing an LED array module according to a second embodiment of the present invention;
FIG. 13 is a perspective view showing an example of the method of manufacturing an LED array module of FIG. 12;
FIG. 14 is a sectional view showing an LED array module manufactured by the method of manufacturing an LED array module according to the second embodiment of the present invention;
FIG. 15 is a flowchart explaining a method of manufacturing an LED array module according to a third embodiment of the present invention;
FIG. 16 is a sectional view showing an LED array module manufactured by the method of manufacturing an LED array module according to the third embodiment of the present invention;

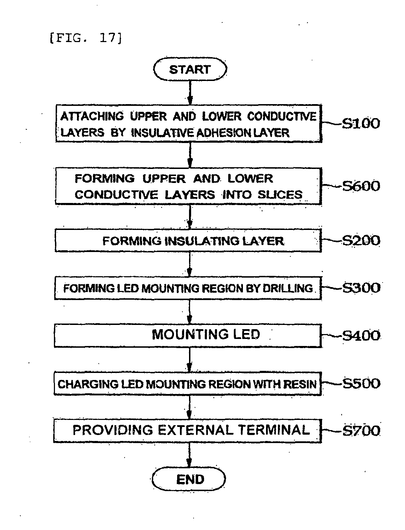

FIG. 17 is a flowchart explaining a method of manufacturing an LED array module according to another embodiment of the present invention; and

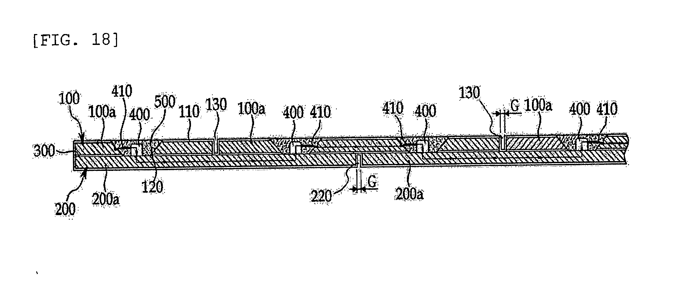

FIG. 18 is a sectional view showing an LED array module manufactured by the method of manufacturing an LED array module according to the fourth embodiment of the present invention.

### DESCRIPTION OF THE PREFERRED EMBODIMENTS

Hereinafter, preferred embodiments of the present invention will be described in detail with reference to the attached drawings.

### [First embodiment of method of manufacturing LED array module]

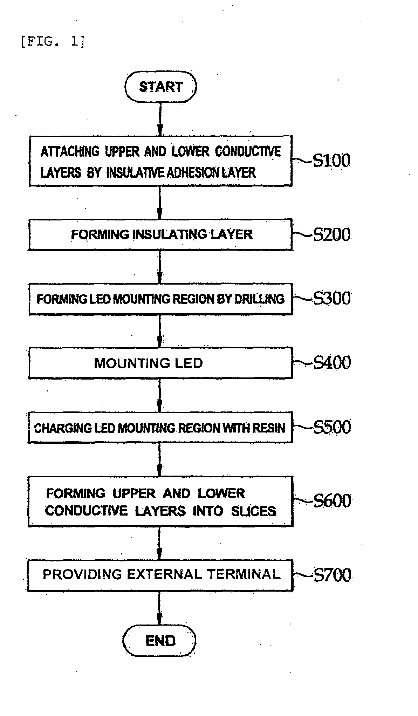

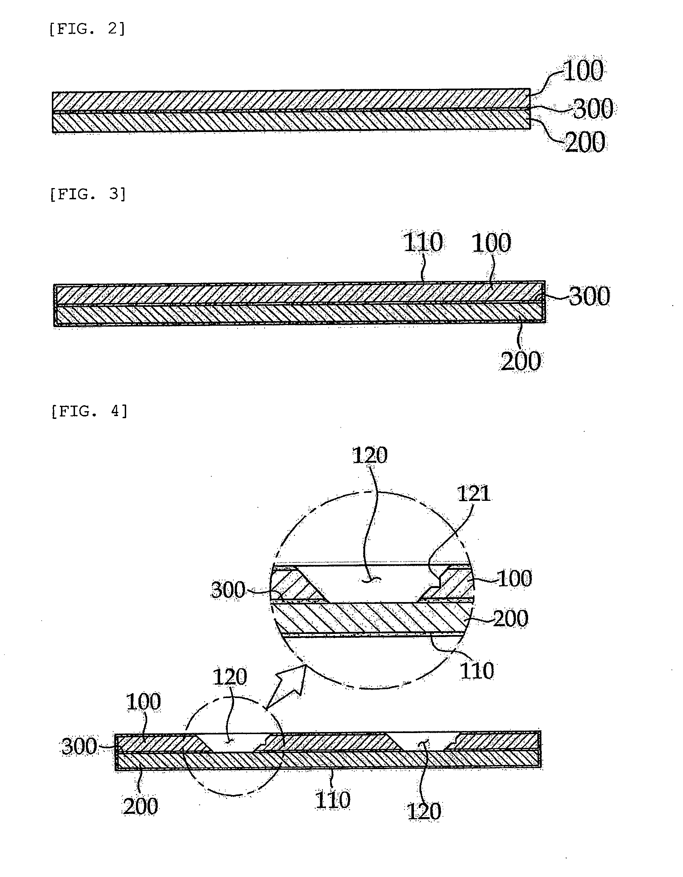

FIG. 1 is a flowchart explaining a method of manufacturing an LED array module according to a first embodiment of the present invention, and FIGS. 2 to 9 are sectional views showing a process of manufacturing an LED array module depending on FIG. 1.

In the method of manufacturing an LED array module according to a first embodiment of the present invention, an LED array module is manufactured using an upper conductive layer 100 and a lower conductive layer 200 having a predetermined size. Basically, the method includes the following six steps.

In the first step (S100), an upper conductive layer 100 is attached to a lower conductive layer 200. In this case, the upper conductive layer 100 and the lower conductive layer 200 are attached to each other by an insulative adhesion layer 300 as an intermediate layer.

As shown in FIG. 2, the insulative adhesion layer 300 is disposed between the upper conductive layer 100 and the lower conductive layer 200. The insulative adhesion layer may be obtained by applying an adhesive film onto the lower conductive layer 200, disposing the upper conductive layer onto the adhesive film and then pressing the upper conductive layer 100 and the lower conductive layer 200 to attach them to each other and insulate them from each other.

Meanwhile, the upper conductive layer 100 and the lower conductive layer 200 are made of a conductive material. Preferably, an aluminum thin film, a metal thin film, a conductive polyester thin film or a silicon thin film, which is commonly used in a substrate, may be used as the upper conductive layer 100 and the lower conductive layer 200. In the preferred embodiments of the present invention, in order to maximize the heat radiation effect, it is most preferred that an aluminum thin film, which has a high radiation efficiency and a low price, be used as the upper conductive layer 100 and the lower conductive layer 200

Particularly, in consideration of heat emitted from LEDs 400, the upper conductive layer 100 and the lower conductive layer 200 are formed to such a thickness that the cooling effect can be increased. That is, each of the upper conductive layer 100 and the lower conductive layer 200 has a thickness of 0.5 - 2.5 mm. However, considering the amount of heat emitted from LEDs 400, the thickness thereof may be increased. In the preferred embodiments of the present invention, it is preferred that the upper conductive layer 100 be thicker than the lower conductive layer 200. The reason for this is that the lower conductive layer 200 substantially functions as a radiation plate because LEDs 400 directly adheres closely to the lower conductive layer 200.

The upper conductive layer 100 and the lower conductive layer 200 may be formed in various shapes. For instance, the upper conductive layer 100 and the lower conductive layer 200 may be formed in a rectangular shape in which the length is longer than the width, or may be formed in a disc shape. Here, the upper conductive layer 100 and the lower conductive layer 200 having a rectangular shape will be described. The upper conductive layer 100 and the lower conductive layer 200 having a disc shape will be described in detail in the following modified embodiment of the present invention.

In the second step (S200), an insulating layer 110 is formed over the entire surface of the upper conductive layer 100 and the lower conductive layer 200.

As shown in FIG. 3, the insulating layer 110, which is an oxide film, is formed on the exposed surface of the entire surface of the upper conductive layer 100 and the lower conductive layer 200. The material of the insulating layer 110 may be selected depending on the material of each of the upper conductive layer 100 and the lower conductive layer 200. For example, when each of the upper conductive layer 100 and the lower conductive layer 200 is an silicon thin film, a silicon oxide film may be used as the insulating layer 110, and, when each of the upper conductive layer 100 and the lower conductive layer 200 is an aluminum thin film, an aluminum oxide film may be used as the insulating layer 110. In addition, a chromium oxide film may be used as the insulating layer 110. Since methods of forming such an oxide film are generally known, descriptions thereof will be omitted.

In the third step (S300), a plurality of LED mounting regions are formed. The LED mounting regions are formed by machining the upper conductive layer 100. In this case, as shown in FIG. 4, the LED mounting regions may be formed by drilling the upper conductive layer 100 together with the insulative adhesion layer 300, so that the lower conductive layer may be exposed outward.

In this case, the LED mounting regions may be formed such that they are disposed in a row along the length direction of the upper conductive layer 100 or such that they are disposed in a lattice shape of two or more rows. Further, each of the LED mounting regions may be formed in a head-cut conical shape whose top diameter is greater than the bottom diameter thereof. That is, each of the LED mounting regions is formed in a head-cut conical shape in order to allow the LED mounting region to function as a reflection plate as well as to mount an LED in the LED mounting region.

Meanwhile, in the third step (S300), each of the LED mounting regions 120 may be provided therein with a wire bonding connection part 121. The wire bonding connection part 121 serves to easily provide a wire 410 in the upper conductive layer 100 at the time of providing LED 400.

In the fourth step (S400), an LED 400 is mounted in each of the LED mounting regions. In this case, the LED 400 is fabricated by a commonly-used technology and is used in the form of a bulb or lamp for displays. Further, methods of mounting the LED 400 are changed by the number of wires for power supply.

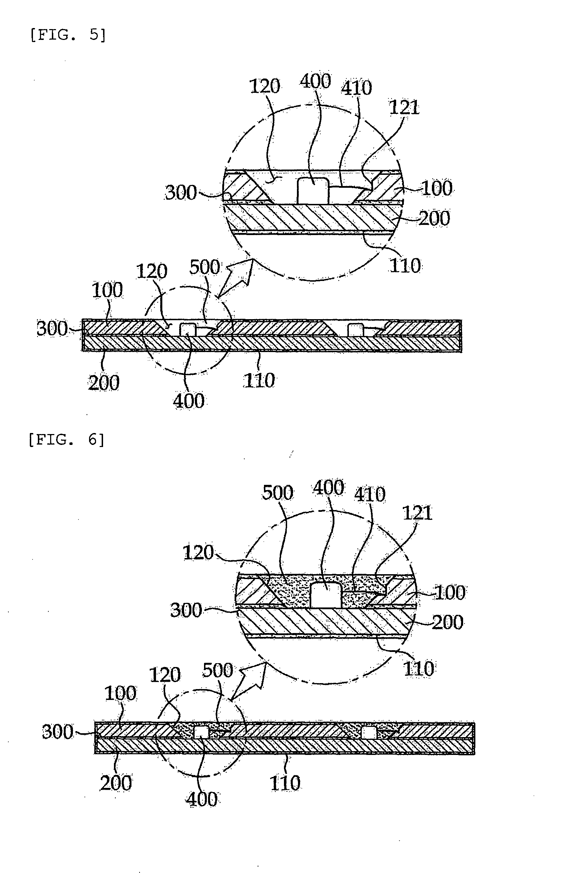

FIG. 5A is a sectional view showing the state in which power is supplied to the LED 400 by one wire 410. Here, one end of the LED 400 directly comes into contact with the top surface of the lower conductive layer 200, and the other end thereof is connected to the wire 410 such that power supplied to the LED 400 by the wire 410 coming into contact with the wire bonding connection part 121 provided in the LED mounting region.

FIG. 5B is another sectional view showing the state in which power is supplied to the LED 400 by a pair of wires 410 and 420. Here, ends of the pair of wires 410 and 420 are respectively connected to the upper conductive layer 100 and the lower conductive layer 200. That is, the end of one wire 410 is connected to the wire bonding connection part 121 to electrically communicate with the upper conductive layer 100, and an end of the other wire 420 is connected to the upper surface of the lower conductive layer 200, which is exposed outward because of the formation of the LED mounting region.

In the fifth step (S500), each of the LED mounting regions 120 is charged with a resin 500. FIG. 6 is a sectional view showing the state in which the LED mounting region is charged with the resin 500. The resin 500 serves to separate the upper conductive layer 100 and the lower conductive layer 200 from each other such that they are electrically connected with each other. Further, the resin 500 serves to fill the LED mounting region 120 as well as to protect the LED 400. Furthermore, the resin 500 serves to fix the wire 410 such that the wire 410 is not electrically separated from the wire bonding connection part 121. It is preferred that a synthetic resin, which has insulating properties and is transparent so that the light emitted from the LED 400 can be transmitted, be used as the resin 500.

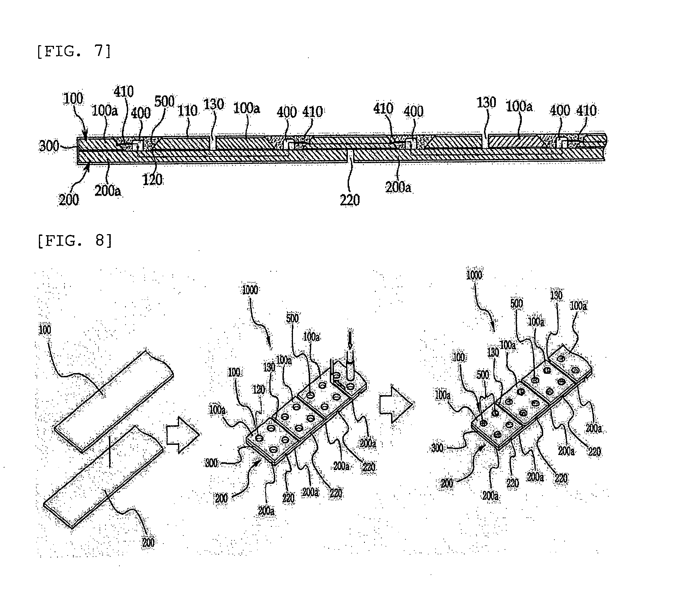

In the sixth step (S600), the upper conductive layer 100 and the lower conductive layer 200 are divided into a plurality of slices 100a and a plurality of slices 200a, respectively. FIG. 7 is a sectional view showing the state in which the upper conductive layer 100 and the lower conductive layer 200 are divided into a plurality of slices, respectively. For this purpose, upper separation grooves 130 and lower separation grooves 220 are respectively formed in the upper conductive layer 100 and the lower conductive layer 200 in parallel with each other. In FIG. 7, the arrow indicates current flow.

As shown in FIG. 7, the upper separation grooves 130 and the lower separation grooves 220 are respectively formed in the width direction of the upper conductive layer 100 and in the width direction of the lower conductive layer 200. In this case, the upper separation grooves 130 are formed in the upper conductive layer 100 every two LED mounting regions, and lower separation grooves 220 are formed in the lower conductive layer 200 such that each of the lower separation grooves 220 is disposed between the two upper separation grooves 130. Therefore, the slices 100a divided from the upper conductive layer 100 and the slices 200a divided from the lower conductive layer 200 are disposed in zigzags. Further, each of the slices 100a is mounted with two LEDs 400.

When the sixth step (S600) is performed, as shown in FIG. 8, an LED array module including a plurality of slices 100a, each being provided with two LED mounting regions 120, can be obtained.

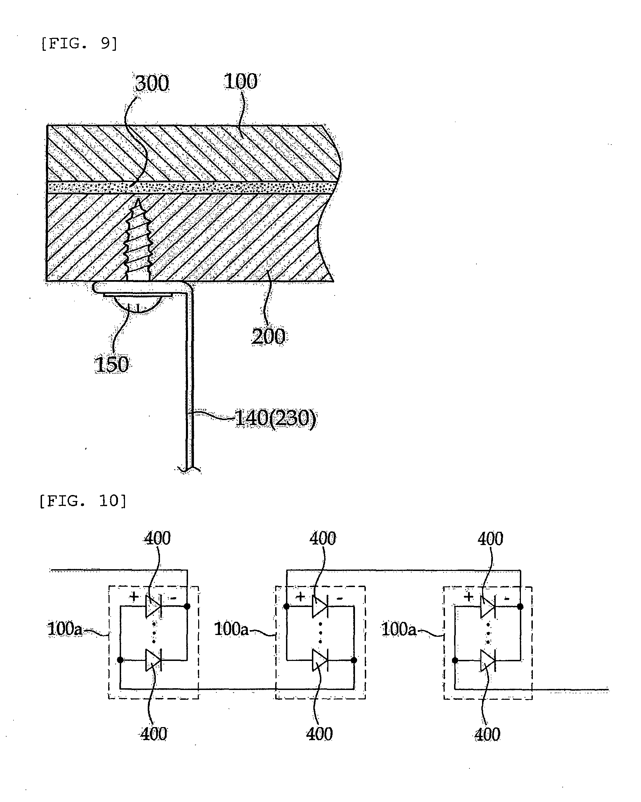

Meanwhile, as shown in FIG. 9, in order to externally supply power, the method of manufacturing an LED array module according to the first embodiment of the present invention may further include the step of: providing external terminals 140 and 230 having polarity opposite to each other to the upper conductive layer 100 and the lower conductive layer 200, respectively. The external terminals 140 and 230 for power supply are provided at both ends of the upper conductive layer and the lower conductive layer by screwing or attaching.

FIG. 9 is a sectional view showing an example of providing external terminals in the method of manufacturing an LED array module according to the first embodiment of the present invention. FIG. 9 shows the state in which external terminals 140 and 230 are fixed using a screw 150.

Meanwhile, the present invention provides an LED array module 1000 manufactured by the method of manufacturing an LED array module according to the first embodiment of the present invention. As shown in FIG. 8, the LED array module 1000 is configured such that a plurality of slices 100a constituting the upper conductive layer 100 and a plurality of slices 200a constituting the lower conductive layer 200 cross each other in a state in which they can be insulated from each other.

Further, as shown in FIGS. 7 and 8, in the LED array module 1000, an upper conductive layer 100 is integrally attached to a lower conductive layer 200 by an insulative adhesion layer 300 as an intermediate layer. In this case, an insulating layer 110 is formed on the entire exposed surface of the upper conductive layer 100 and the lower conductive layer 200. Further, in the LED array module, upper separation grooves 130 and lower separation grooves 220 are respectively formed in the upper conductive layer 100 and the lower conductive layer 200 in the width direction thereof at regular intervals such that the upper conductive layer 100 and the lower conductive layer 200 are respectively composed of a plurality of slices 100a and a plurality of slices 200a. In particular, each of the upper separation grooves 130 is formed in the upper conductive layer 100 every two LED mounting regions, and each of the lower separation grooves 220 is formed in the lower conductive layer 200 such that each of the lower separation grooves 220 is disposed between the two upper separation grooves 130. Further, in the upper conductive layer 100, two LED mounting regions 120 are formed in each of the slices 100a by machining. In this case, each of the LED mounting regions is formed by machining the upper conductive layer 100 together with the insulative adhesion layer 300 such that the upper surface of the lower conductive layer 200 is exposed. This LED mounting region is mounted therein with LED and then charged with a resin 500 having insulating properties and transparency.

The LED array module 1000 manufactured in this way may be used such that two LEDs 400 are connected in parallel to each other based on any one upper separation groove 130 or lower separation groove 220. Further, as shown in FIG. 8, when the lower separation grooves are cut such that four LEDs 400 become one set, the parallel connected LEDs can be used as an LED set connected in series.

Meanwhile, the method of manufacturing a LED array module according to the first embodiment of the present invention can be modified depending on the shape of the upper conductive layer 100 and the lower conductive layer 200. Hereinafter, a modified embodiment of the method of the first embodiment will be described as follows.

### [Modified embodiment of the first embodiment of a method of manufacturing an LED array module]

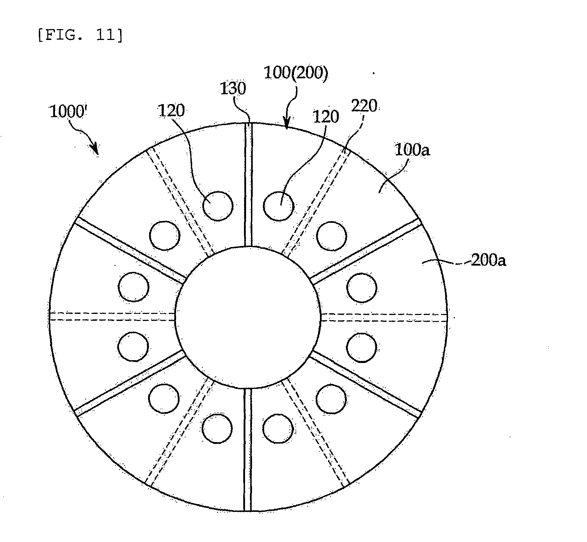

FIG. 11 is a plan view showing a modified embodiment of the LED array module 1000' manufactured by the method according to the first embodiment of the present invention. Hereinafter, only the different components between a modified embodiment and the first embodiment will be described. The reference numerals used in the first embodiment are re-used unchanged as those of the modified embodiment.

Comparing a modified embodiment with the first embodiment, the modified embodiment is different from the first embodiment in terms of the shape of the upper conductive layer 100 and the lower conductive layer 200, the position of the LED mounting regions 120 and the position of the upper separation grooves 130 and the lower separation grooves 220. Therefore, only these differences will be described.

As shown in FIG. 11, each of the upper conductive layer 100 and the lower conductive layer 200 is fabricated in the form of a disc. Further, the LED mounting regions 120 are formed on the imaginary circumference having a predetermined radius from the center of the disc-shaped upper conductive layer 100 at regular intervals. In FIG. 11, the LED mounting regions are formed in a row, but may be formed in two or more rows.

Further, the slices 100a constituting the upper conductive layer 100 and the slices 200a constituting the lower conductive layer 200 are also respectively fabricated in the form of an arc. For this purpose, the upper separation grooves 130 and the lower separation grooves 220 are radially disposed from the center of the upper conductive layer 100 and the lower conductive layer 200 at regular intervals, respectively. In this case, the upper separation grooves 130 are disposed at regular intervals every two LED mounting regions, and the lower separation grooves 220 are disposed such that each of them is located between the two adjacent upper separation grooves 130.

Therefore, as in the first embodiment described with reference to FIG. 10, in the modified embodiment, a pair of LEDs 400 mounted in each of the slices 100a are connected in parallel to each other, and the adjacent slices 100a are connected in series to each other.

Meanwhile, the present invention provides an LED array module 1000' manufactured by the method of manufacturing an LED array module according to the modified embodiment of the first embodiment of the present invention. As shown in FIG. 11, the LED array module 1000' is fabricated in the form of a disc. This LED array module 1000' is entirely identical with the LED array module 1000 in its structure, but is different from the LED array module 1000 in its overall shape and the position of the upper separation grooves 130 and the lower separation grooves 220. That is, each of the upper conductive layer 100 and the lower conductive layer 200 is fabricated in the form of a disc, and the upper separation grooves 130 and the lower separation grooves 220 are respectively formed in the upper conductive layer 100 and the lower conductive layer 200 at regular intervals in the radial direction from the center of the disc.

### [Second embodiment of a method of manufacturing an LED array module]

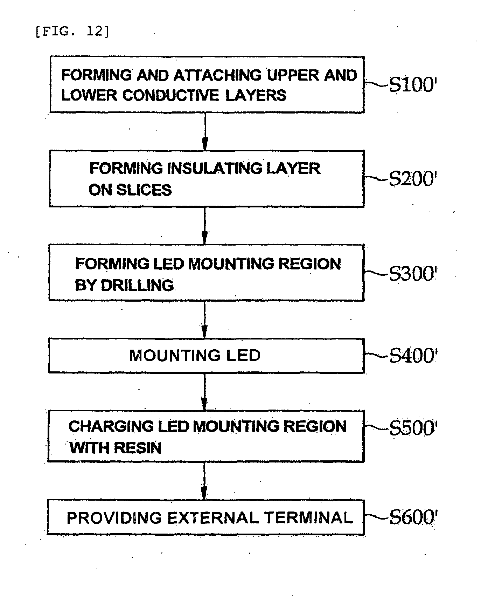

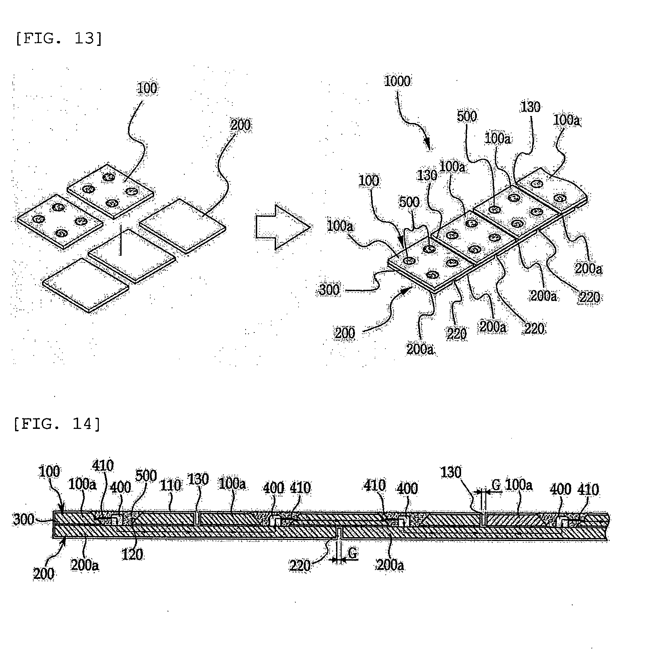

FIG. 12 is a flowchart explaining a method of manufacturing an LED array module according to a second embodiment of the present invention, and FIG. 13 is a sectional view showing an LED array module manufactured by the method according to the second embodiment of the present invention. Here, only the difference between the second embodiment and the first embodiment will be described. For the sake of explanation, the reference numerals used in the first embodiment are re-used unchanged as those of the second embodiment.

The method of manufacturing an LED array module according to the second embodiment of the present invention includes six steps. Comparing the method of the second embodiment with the method of the first embodiment, the method of the second embodiment is different from the method of the first embodiment in the point that the upper conductive layer 100 and the lower conductive layer 200 are formed using a plurality of slices 100a and a plurality of slices 200a, respectively. This difference will be described in more detail in the following fist step (S100') and second step (S200') of the second embodiment.

In the first step (S100'), a plurality of slices 100a and a plurality of slices 200a are formed into an upper conductive layer 100 and a lower conductive layer 200, respectively, and the upper conductive layer 100 and the lower conductive layer 200 are integrated with each other by an insulative adhesion layer 300.

The upper conductive layer 100 is formed by disposing the plurality of slices 100a in the same plane. In this case, the plurality of slices 100a is disposed in the same plane at regular intervals. The lower conductive layer 200 is also formed in the same manner as the upper conductive layer 100. The upper conductive layer 100 and the lower conductive layer 200 formed in this way are integrated with each other by the insulative adhesion layer 300.

Concretely, referring to FIG. 13, a plurality of slices 200a are disposed in the same plane in a row at regular intervals to form a lower conductive layer 200, an insulative adhesion layer 300 is applied onto the lower conductive layer 200, and then a plurality of slices 100a are disposed on the insulative adhesion layer 300 at regular intervals to form an upper conductive layer 100. In this case, each of the slices 100a overlaps with each of the slices 200a in half, and thus the slices 100a and the slices 200a zigzag and cross each other.

In the second embodiment, as described in the first embodiment and the modified embodiment thereof, the shape of each of the slices 100a and 200a is changed depending on the shape of each of the upper conductive layer 100 and the lower conductive layer 200. That is, when each of the upper conductive layer 100 and the lower conductive layer 200 has a rectangular shape, the slices 100a and 200a having a rectangular shape are used. Further, when each of the upper conductive layer 100 and the lower conductive layer 200 has a disc shape, the slices 100a and 200a having an arc shape are used.

In the second step (S200'), an insulating layer 110 is formed over the entire exposed surface of the upper conductive layer 100 and the lower conductive layer 200. This insulating layer serves to protect the slices 100a and 200a and maintain electrical safety. In this case, as shown in FIG. 13, the insulating layer 110 may be formed over the entire exposed surface of the upper conductive layer 100 and the lower conductive layer 200.

In the third step (S300'), a plurality of LED mounting regions 120 is formed; in the fourth step (S400'), LEDs 400 are respectively mounted in the LED mounting regions; in the fifth step (S500'), the LED mounting regions 120 is charged with a resin 500; and in the sixth steps (S600'), external terminals 140 and 230 are provided for the purpose of power supply. The steps (S300' ~ S500') are performed in the same manner as the steps (S300 ~ S500) of the first embodiment, and the step (S600') is performed in the same manner as the step (S700) of the first embodiment. Therefore, detailed descriptions thereof will be omitted.

In particular, in the third step (S300'), the LED mounting regions 120 are respectively formed in the slices 100a, but, as shown in FIGS. 8 and 11, it is preferred that each of the LED mounting regions 120 be disposed between the adjacent upper and lower separation grooves 130 and 220.

The present invention provides an LED array module manufactured by the method of the second embodiment. The LED array module manufactured by the method of the second embodiment is identical with the LED array module (1000, 1000'), shown in FIGS. 8 and 11, manufactured by the method of the first embodiment, except for the insulating layer 110. That is, in the LED array module manufactured by the method of the second embodiment, as shown in FIG. 13, this insulating layer 110 is formed even on the inner wall of the gap (G) between the slices 100a.

### [Third embodiment of a method of manufacturing an LED array module]

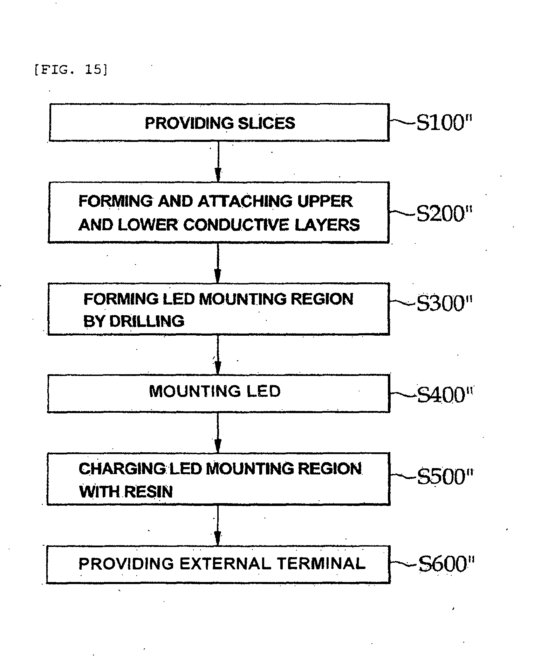

FIG. 14 is a flowchart explaining a method of manufacturing an LED array module according to a third embodiment of the present invention, and FIG. 15 is a sectional view showing an LED array module manufactured by the method according to the third embodiment of the present invention. Here, only the difference between the third embodiment and the second embodiment will be described. For the sake of explanation, the reference numerals used in the third embodiment are re-used unchanged as those of the first and second embodiments.

The method of manufacturing an LED array module according to the third embodiment of the present invention includes six steps. Comparing the method of the third embodiment with the method of the second embodiment, the method of the third embodiment is different from the method of the second embodiment in the point that the insulating layer 110 is not formed. In the method of the third embodiment, only the first step (S100") of providing slices 100a and slices 200a respectively constituting an upper conductive layer 100 and a lower conductive layer 200 and the second step (S200") of attaching the upper conductive layer 100 to the lower conductive layer 200 will be briefly described.

In the first step (S100"), a plurality of slices 100a and a plurality of slices 200a are provided. In this case, as in the methods of the first and second embodiments, each of the slices 100a and 200a may have a rectangular or arc shape depending on the shape of the upper conductive layer 100 and the lower conductive layer 200.

In the second step (S200"), as in the second step (S200') of the second embodiment, the upper conductive layer 100 is attached to the lower conductive layer 200 using an insulative adhesion layer 300. In this case, the slices 100a and 200a constituting the upper conductive layer 100 and the lower conductive layer 200 are disposed at a predetermined gap (G). Therefore, adjacent slices 100a are not electrically connected with each other.

In the third step (S300"), a plurality of LED mounting regions 120 is formed; in the fourth step (S400"), LEDs 400 are respectively mounted in the LED mounting regions; in the fifth step (S500"), the LED mounting regions 120 is charged with a resin 500; and in the sixth steps (S600"), external terminals 140 and 230 are provided for the purpose of power supply. The steps (S300" ~ S500") are performed in the same manner as the steps (S300 ~ S500) of the first embodiment, and the step (S600") is performed in the same manner as the step (S700) of the first embodiment. Therefore, the detailed description thereof will be omitted.

The present invention provides an LED array module manufactured by the method of the third embodiment. The LED array module manufactured by the method of the third embodiment is identical with the LED array module (1000, 1000'), shown in FIG. 15, manufactured by the method of the first embodiment, except that the insulating layer 110 is removed from each of the slices 100a and 200a.

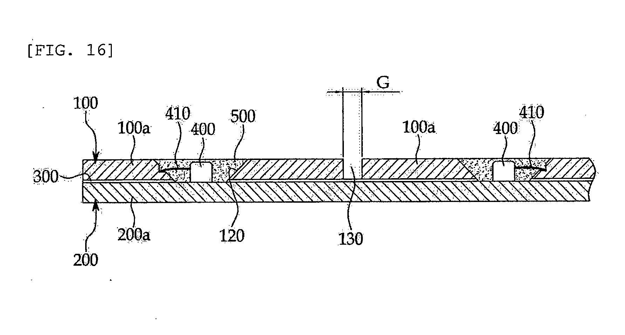

FIG. 16 is a flowchart explaining a method of manufacturing an LED array module according to another embodiment of the present invention. The method according to another embodiment of the present invention includes six steps. In the first step (S100), an upper conductive layer 100 is attached to a lower conductive layer 200 by an insulative adhesion layer 300 as an intermediate layer. In the second step (S200), upper separation holes 130 and lower separation holes 220 are respectively formed in the upper conductive layer 100 and the lower conductive layer 200 abreast in a width direction such that each of the upper conductive layer 100 and the lower conductive layer 100 is divided into a plurality of slices 100a and 200a.

In the third step (S300), a plurality of LED mounting regions 120 is formed by machining the upper conductive layer 100 such that the upper surface of the lower conductive layer 200 is exposed. In the fourth step (S400), an LED 400 is mounted in each of the LED mounting regions 120 such that power is supplied to the LED 400 by the lower conductive layer 200 and the upper conductive layer 100. In the fifth step (S500), each of the LED mounting regions 120 is charged with a resin 500 having insulation properties and transparency. In the sixth step (S600), an insulating layer 110 is formed over the entire exposed surface of the upper conductive layer 100 and the lower conductive layer 200.

As described above, according to the LED array module of present invention, there are the following advantages.
1) The heat radiation effect is excellent.
2) The LED array module can cope with the power requirements because a plurality of LEDs is connected in series-parallel combination.
3) Upper and lower conductive layers can be formed in various shapes, such as those of a square, a disk, etc.

Although the preferred embodiments of the present invention have been disclosed for illustrative purposes, those skilled in the art will appreciate that various modifications, additions and substitutions are possible, without departing from the scope of the invention as disclosed in the accompanying claims.

## Claims

1. A method of manufacturing an LED array module, comprising the steps of:
attaching (S100) an upper conductive layer (100) to a lower conductive layer (200) by an insulative adhesion layer (300) as an intermediate layer;
forming (S200) an insulating layer (110) over the entire exposed surface of the upper conductive layer (100) and the lower conductive layer (200);
forming (S300) a plurality of LED mounting regions (120) by machining the upper conductive layer (100) such that the upper surface of the lower conductive layer (200) is exposed;
mounting (S400) an LED (400) in each of the LED mounting regions (120) such that power is supplied to the LED (400) by the lower conductive layer (200) and the upper conductive layer (100);
charging (S500) each of the LED mounting regions (120) with a resin (500) having insulation properties and transparency; and
respectively forming(S600) upper separation grooves (130) and lower separation grooves (220) in the upper conductive layer (100) and the lower conductive layer (200) abreast in a width direction such that each of the upper conductive layer (100) and the lower conductive layer (100) is divided into a plurality of first slices (100a) and a plurality of second slices (200a).

2. A method of manufacturing an LED array module, comprising the steps of:
disposing (S 100') a plurality of second slices (200a) in the same plane at regular intervals to form a lower conductive layer (200), applying an insulative adhesion layer (300) onto the lower conductive layer (200), and then disposing a plurality of first slices (100a) on the insulative adhesion layer (300) in zigzags to form an upper conductive layer (100) integrated with the lower conductive layer (200);
forming (S200') an insulating layer (110) over the entire exposed surface of the upper conductive layer (100) and the lower conductive layer (200);
forming (S300') a plurality of LED mounting regions (120) by machining the upper conductive layer (100) and the insulative adhesion layer such that the upper surface of the lower conductive layer (200) is exposed by the first slices (100a) of the upper conductive layer disposed on the second slices (200a) of the lower conductive layer;
mounting (S400') an LED (400) in each of the LED mounting regions (120) such that power is supplied to the LED (400) by the lower conductive layer (200) and the upper conductive layer (100); and
charging (S500) each of the LED mounting regions (120) with a resin (500) having insulation properties and transparency.

3. A method of manufacturing an LED array module, comprising the steps of:
providing (S100") a plurality of first slices (100a) and a plurality of second slices (200a);
disposing (S200") the plurality of first slices (100a) in the same plane at regular intervals to form an upper conductive layer (100), disposing the plurality of second slices (200a) on the upper conductive layer (100) in zigzags to form an lower conductive layer (200) such that the second slices (200a) and the first slices (100a) cross each other , and then attaching the upper conductive layer (100) to the lower conductive layer (200) by an insulative adhesion layer (300) as an intermediate layer;
forming (S300") a plurality of LED mounting regions (120) by machining the upper conductive layer (100) such that the upper surface of the lower conductive layer (200) is exposed;
mounting (S400") an LED (400) in each of the LED mounting regions (120) such that power is supplied to the LED (400) by the lower conductive layer (200) and the upper conductive layer (100); and
charging (S500") each of the LED mounting regions (120) with a resin (500) having insulation properties and transparency.

4. A method of manufacturing an LED array module, comprising the steps of:
attaching (S100) an upper conductive layer (100) to a lower conductive layer (200) by an insulative adhesion layer (300) as an intermediate layer;
respectively forming (S200) upper separation grooves (130) and lower separation grooves (220) in the upper conductive layer (100) and the lower conductive layer (200) abreast in a width direction such that each of the upper conductive layer (100) and the lower conductive layer (200) is divided into a plurality of first slices (100a) and a plurality of second slices (200a);
forming (S300) a plurality of LED mounting regions (120) by machining the upper conductive layer (100) such that the upper surface of the lower conductive layer (200) is exposed;
mounting (S400) an LED (400) in each of the LED mounting regions (130) such that power is supplied to the LED (400) by the lower conductive layer (200) and the upper conductive layer (100);
charging each of the LED mounting regions (120) with a resin (500) having insulation properties and transparency (S500); and
forming (S600) an insulating layer (110) over the entire exposed surface of the upper conductive layer (100) and the lower conductive layer (200).

5. The method of manufacturing an LED array module according to any one of claims 1 to 4, wherein each of the upper conductive layer (100) and the lower conductive layer (200) has a rectangular shape, and
the LED mounting regions are disposed in a row or in a lattice shape of two or more rows.

6. The method of manufacturing an LED array module according to any one of claims 1 to 4, wherein each of the upper conductive layer (100) and the lower conductive layer (200) has a disc shape, and
the LED mounting regions are radially disposed from the center of the upper conductive layer in the form of at least one row.

7. The method of manufacturing an LED array module according to any one of claims 1 to 4, wherein each of the upper conductive layer (100) and the lower conductive layer (200) is an aluminum thin film, a metal thin film, a conductive polyester thin film or a silicon thin film.

8. The method of manufacturing an LED array module according to any one of claims 1 to 4, wherein each of the upper conductive layer (100) and the lower conductive layer (200) has a thickness of 0.5 - 2.5 mm.

9. The method of manufacturing an LED array module according to claim 1 or 2, wherein the insulating layer (110) is a silicon oxide film, an aluminum oxide film or a chromium oxide film.

10. The method of manufacturing an LED array module according to any one of claims 1 to 4, wherein each of the LED mounting regions (120) has a head-cut conical shape, and is provided therein with a wire bonding connection part (121).

11. An LED array module, wherein an upper conductive layer (100) is integrally attached to a lower conductive layer (200) by an insulative adhesion layer (300) as an intermediate layer, and an insulating layer (110) is formed over the entire exposed surface of the upper conductive layer (100) and the lower conductive layer (200);
a plurality of LED mounting regions (120) is formed in the upper conductive layer (100) such that the upper surface of the lower conductive layer (200) is exposed;
an LED (400) is mounted in each of the LED mounting regions (120) such that power is supplied to the LED (400) by the lower conductive layer (200) and the upper conductive layer (100), and each of the LED mounting regions (120) is charged with a resin (500) having insulation properties and transparency; and
upper separation grooves (130) are formed in the upper conductive layer (100) at regular intervals in a width direction every the two LED mounting regions, and lower separation grooves (220) are formed in the lower conductive layer (200) such that each of the lower separation grooves (220) is disposed between the two upper separation grooves (130).

12. The LED array module according to claim 11,
wherein each of the upper conductive layer (100) and the lower conductive layer (200) has a rectangular shape, and
the LED mounting regions are disposed in a lattice shape of one or more rows.

13. The LED array module according to claim 11,
wherein each of the upper conductive layer (100) and the lower conductive layer (200) has a disc shape, and
the LED mounting regions are radially disposed from the center of the upper conductive layer in the form of at least one row.

## Patentansprüche

1. Verfahren zum Herstellen eines LED-Array-Moduls, die Schritte aufweisend:
• Aufbringen (S100) einer oberen leitfähigen Schicht (100) auf einer unteren leitfähigen Schicht (200) mittels einer isolierenden Haftschicht (300) als eine Zwischenschicht;
• Bilden (S200) einer Isolierschicht (110) über der gesamten freiliegenden Oberfläche der oberen leitfähigen Schicht (100) und der unteren leitfähigen Schicht (200);
• Bilden (S300) einer Mehrzahl von LED-Montagebereichen (120) mittels Bearbeitens der oberen leitfähigen Schicht (100) derart, dass die obere Oberfläche der unteren leitfähigen Schicht (200) freigelegt ist;
• Montieren (S400) jeweils einer LED (400) in einem LED-Montagebereich (120) derart, dass Strom mittels der unteren leitfähigen Schicht (200) und der oberen leitfähigen Schicht (100) an die LED (400) zugeführt wird;
• Füllen (S500) jedes LED-Montagebereiches (120) mit einem Harz (500), das Isolationseigenschaften und Transparenz aufweist; und
• Bilden (S600) nebeneinander in einer Breitenrichtung von oberen Trennaussparungen (130) in der oberen leitfähigen Schicht (100) und von unteren Trennaussparungen (220) in der unteren leitfähigen Schicht (200), so dass die obere leitfähige Schicht (100) in eine Mehrzahl von ersten Scheiben (100a) und die untere leitfähige Schicht (1/200) in eine Mehrzahl von zweiten Scheiben (200a) aufgeteilt ist.

2. Verfahren zum Herstellen eines LED-Array-Moduls, die Schritte aufweisend:
• Anordnen (S100') einer Mehrzahl von zweiten Scheiben (200a) in der gleichen Ebene in regelmäßigen Abständen, um eine untere leitfähige Schicht (200) zu bilden, Aufbringen einer isolierenden Haftschicht (300) auf die untere leitfähige Schicht (200), und dann Anordnen einer Mehrzahl von ersten Scheiben (100a) auf der isolierenden Haftschicht (300) im Zickzack, um eine obere leitfähige Schicht (100) integriert mit der unteren leitfähigen Schicht (200) zu bilden;
• Bilden (S200') einer Isolierschicht (110) über der gesamten freiliegenden Oberfläche der oberen leitfähigen Schicht (100) und der unteren leitfähigen Schicht (200);
• Bilden (S300') einer Mehrzahl von LED-Montagebereichen (120) mittels Bearbeitens der oberen leitfähigen Schicht (100) und der isolierenden Haftschicht derart, dass die obere Oberfläche der unteren leitfähigen Schicht (200) freigelegt ist von den ersten Scheiben (100a) der oberen leitfähigen Schicht, die auf den zweiten Scheiben (200a) der unteren leitenden Schicht angeordnet sind;
• Montieren (S400') jeweils einer LED (400) in einem LED-Montagebereich (120) derart, dass Strom mittels der unteren leitfähigen Schicht (200) und der oberen leitfähigen Schicht (100) an die LED (400) zugeführt wird; und
• Füllen (S500') jedes LED-Montagebereiches (120) mit einem Harz (500), das Isolationseigenschaften und Transparenz aufweist.

3. Verfahren zum Herstellen eines LED-Array-Moduls, die Schritte aufweisend:
• Bereitstellen (S100") einer Mehrzahl von ersten Scheiben (100a) und einer Mehrzahl von zweiten Scheiben (200a);
• Anordnen (S200") der Mehrzahl von ersten Scheiben (100a) in der gleichen Ebene in regelmäßigen Abständen, um eine obere leitfähige Schicht (100) zu bilden, Anordnen der Mehrzahl von zweiten Scheiben (200a) auf der oberen leitfähigen Schicht (100) im Zickzack, um eine untere leitfähige Schicht (200) zu bilden derart, dass die zweiten Scheiben (200a) und die ersten Scheiben (100a) einander kreuzen, und dann Aufbringen der oberen leitfähigen Schicht (100) auf der unteren leitfähigen Schicht (200) mittels einer isolierenden Haftschicht (300) als eine Zwischenschicht;
• Bilden (S300") einer Mehrzahl von LED-Montagebereichen (120) mittels Bearbeitens der oberen leitfähigen Schicht (100) derart, dass die obere Oberfläche der unteren leitfähigen Schicht (200) freigelegt ist;
• Montieren (S400") jeweils einer LED (400) in einem LED-Montagebereich (120) derart, dass Strom mittels der unteren leitfähigen Schicht (200) und der oberen leitfähigen Schicht (100) an die LED (400) zugeführt wird; und
• Füllen (S500') jedes LED-Montagebereiches (120) mit einem Harz (500), das Isolationseigenschaften und Transparenz aufweist.

4. Verfahren zum Herstellen eines LED-Array-Moduls, die Schritte aufweisend:
• Aufbringen (S100) einer oberen leitfähigen Schicht (100) auf einer unteren leitfähigen Schicht (200) mittels einer isolierenden Haftschicht (300) als eine Zwischenschicht;
• Bilden (S200) nebeneinander in einer Breitenrichtung von oberen Trennaussparungen (130) in der oberen leitfähigen Schicht (100) und von unteren Trennaussparungen (220) in der unteren leitfähigen Schicht (200), so dass die obere leitfähige Schicht (100) in eine Mehrzahl von ersten Scheiben (100a) und die untere leitfähige Schicht (200) in eine Mehrzahl von zweiten Scheiben (200a) aufgeteilt ist;
• Bilden (S300) einer Mehrzahl von LED-Montagebereichen (120) mittels Bearbeitens der oberen leitfähigen Schicht (100) derart, dass die obere Oberfläche der unteren leitfähigen Schicht (200) freigelegt ist;
• Montieren (S400) jeweils einer LED (400) in einem LED-Montagebereich (120) derart, dass Strom mittels der unteren leitfähigen Schicht (200) und der oberen leitfähigen Schicht (100) an die LED (400) zugeführt wird;
• Füllen (S500) jedes LED-Montagebereiches (120) mit einem Harz (500), das Isolationseigenschaften und Transparenz aufweist; und
• Bilden (S600) einer Isolierschicht (110) über der gesamten freiliegenden Oberfläche der oberen leitfähigen Schicht (100) und der unteren leitfähigen Schicht (200).

5. Verfahren zum Herstellen eines LED-Array-Moduls gemäß einem der Ansprüche 1 bis 4,
wobei die obere leitfähige Schicht (100) und die untere leitfähige Schicht (200) jeweils eine rechteckige Form aufweisen, und
die LED-Montagebereiche in einer Reihe oder in einer Gitterform von zwei oder mehreren Reihen angeordnet sind.

6. Verfahren zum Herstellen eines LED-Array-Moduls gemäß einem der Ansprüche 1 bis 4,
wobei die obere leitfähige Schicht (100) und die untere leitfähige Schicht (200) jeweils eine Scheibenform aufweisen, und
die LED-Montagebereiche radial von der Mitte der oberen leitfähigen Schicht in Form von mindestens einer Reihe angeordnet sind.

7. Verfahren zum Herstellen eines LED-Array-Moduls gemäß einem der Ansprüche 1 bis 4,
wobei die obere leitfähige Schicht (100) und die untere leitfähige Schicht (200) Aluminium-Dünnschichten, Metall-Dünnschichten, leitfähige Polyester-Dünnschichten oder Silizium-Dünnschichten sind.

8. Verfahren zum Herstellen eines LED-Array-Moduls gemäß einem der Ansprüche 1 bis 4,
wobei die obere leitfähige Schicht (100) und die untere leitfähige Schicht (200) eine Dicke von 0,5 - 2,5 mm aufweisen.

9. Verfahren zum Herstellen eines LED-Array-Moduls gemäß Anspruch 1 oder 2,
wobei die Isolierschicht (110) eine Siliziumoxidschicht, eine Aluminiumoxidschicht oder eine Chromoxidschicht ist.

10. Verfahren zum Herstellen eines LED-Array-Moduls gemäß einem der Ansprüche 1 bis 4,
wobei jeder LED-Montagebereiche (120) eine Kegelstumpf-Form aufweist und darin mit einem Drahtanschluss-Verbindungsteil (121) versehen ist.

11. LED-Array-Modul, wobei
eine obere leitende Schicht (100) integral mittels einer isolierenden Haftschicht (300) als eine Zwischenschicht auf einer unteren leitfähigen Schicht (200) aufgebracht ist, und eine Isolierschicht (110) über der gesamten freiliegenden Oberfläche der oberen leitfähigen Schicht (100) und der unteren leitfähigen Schicht (200) ausgebildet ist;
eine Mehrzahl von LED-Montagebereichen (120) in der oberen leitfähigen Schicht (100) ausgebildet ist derart, dass die obere Oberfläche der unteren leitfähigen Schicht (200) freigelegt ist;
jeweils eine LED (400) in einem LED-Montagebereiche (120) montiert ist derart, dass Strom von der unteren leitfähigen Schicht (200) und der oberen leitfähigen Schicht (100) an die LED (400) zugeführt wird, und jeder LED-Montagebereich (120) mit einem Harz (500) gefüllt ist, das Isolationseigenschaften und Transparenz aufweist; und obere Trennaussparungen (130) in regelmäßigen Abständen in einer Breitenrichtung in der oberen leitfähigen Schicht (100) alle zwei LED-Montagebereiche ausgebildet sind, und untere Trennaussparungen (220) in der unteren leitfähigen Schicht (200) gebildet sind derart, dass jede untere Trennaussparung (220) zwischen zwei oberen Trennaussparungen (130) angeordnet ist.

12. LED-Array-Modul gemäß Anspruch 11,
wobei die obere leitfähige Schicht (100) und die untere leitfähige Schicht (200) jeweils eine rechteckige Form aufweisen, und
die LED-Montagebereiche in einer Reihe oder in einer Gitterform von zwei oder mehreren Reihen angeordnet sind.

13. LED-Array-Modul gemäß Anspruch 11,
wobei die obere leitfähige Schicht (100) und die untere leitfähige Schicht (200) jeweils eine Scheibenform aufweisen, und
die LED-Montagebereiche radial von der Mitte der oberen leitfähigen Schicht in Form von mindestens einer Reihe angeordnet sind.

## Revendications

1. Procédé pour fabriquer un module de réseau de DEL, comprenant les étapes consistant à :
fixer (S100) une couche conductrice supérieure (100) sur une couche conductrice inférieure (200) par une couche d'adhésion isolante (300) en tant que couche intermédiaire ;
former (S200) une couche isolante (110) sur toute la surface exposée de la couche conductrice supérieure (100) et de la couche conductrice inférieure (200) ;
former (S300) une pluralité de régions de montage de DEL (120) en usinant la couche conductrice supérieure (100) de sorte que la surface supérieure de la couche conductrice inférieure (200) est exposée ;
monter (S400) une DEL (400) dans chacune des régions de montage de DEL (120) de sorte que l'énergie est fournie à la DEL (400) par la couche conductrice inférieure (200) et la couche conductrice supérieure (100) ;
charger (S500) chacune des régions de montage de DEL (120) avec une résine (500) ayant des propriétés d'isolation et une transparence ; et
former (S600) respectivement des rainures de séparation supérieures (130) et des rainures de séparation inférieures (220) dans la couche conductrice supérieure (100) et la couche conductrice inférieure (200) côte à côte dans le sens de la largeur de sorte que chacune parmi la couche conductrice supérieure (100) et la couche conductrice inférieure (100) est divisée en une pluralité de premières tranches (100a) et en une pluralité de secondes tranches (200a).

2. Procédé pour fabriquer un module de réseau de DEL, comprenant les étapes consistant à :
disposer (S100') une pluralité de secondes tranches (200a) dans le même plan à intervalles réguliers afin de former une couche conductrice inférieure (200), appliquer une couche d'adhésion isolante (300) sur la couche conductrice inférieure (200) et ensuite disposer une pluralité de premières tranches (100a) sur la couche d'adhésion isolante (300) en zigzag afin de former une couche conductrice supérieure (100) intégrée avec la couche conductrice inférieure (200) ;
former (S200') une couche isolante (110) sur toute la surface exposée de la couche conductrice supérieure (100) et de la couche conductrice inférieure (200) ;
former (S300') une pluralité de régions de montage de DEL (120) en usinant la couche conductrice supérieure (100) et la couche d'adhésion isolante de sorte que la surface supérieure de la couche conductrice inférieure (200) est exposée par les premières tranches (100a) de la couche conductrice supérieure disposée sur les secondes tranches (200a) de la couche conductrice inférieure ;
monter (S400") une DEL (400) dans chacune des régions de montage de DEL (120) de sorte que l'énergie est fournie à la DEL (400) par la couche conductrice inférieure (200) et la couche conductrice supérieure (100) ; et
charger (S500) chacune des régions de montage de DEL (120) avec une résine (500) ayant des propriétés d'isolation et une transparence.

3. Procédé pour fabriquer un module de réseau de DEL, comprenant les étapes consistant à :
prévoir (S100") une pluralité de premières tranches (100a) et une pluralité de secondes tranches (200a) ;
disposer (S200") la pluralité de premières tranches (100a) dans le même plan à intervalles réguliers afin de former une couche conductrice supérieure (100), disposer la pluralité de secondes tranches (200a) sur la couche conductrice supérieure (100) en zigzags afin de former une couche conductrice inférieure (200) de sorte que les secondes tranches (200a) et les premières tranches (100a) se croisent, et fixer ensuite la couche conductrice supérieure (100) à la couche conductrice inférieure (200) par une couche d'adhésion isolante (300) en tant que couche intermédiaire ;
former (S300") une pluralité de régions de montage de DEL (120) en usinant la couche conductrice supérieure (100) de sorte que la surface supérieure de la couche conductrice inférieure (200) est exposée ;
monter (S400") une DEL (400) dans chacune des régions de montage de DEL (120) de sorte que l'énergie est fournie à la DEL (400) par la couche conductrice inférieure (200) et la couche conductrice supérieure (100) ; et
charger (S500") chacune des régions de montage de DEL (120) avec une résine (500) ayant des propriétés d'isolation et une transparence.

4. Procédé pour fabriquer un module de réseau de DEL, comprenant les étapes consistant à :
fixer (S100) une couche conductrice supérieure (100) sur une couche conductrice inférieure (200) par une couche d'adhésion isolante (300) en tant que couche intermédiaire ;
former (S200) respectivement des rainures de séparation supérieures (130) et des rainures de séparation inférieures (220) dans la couche conductrice supérieure (100) et la couche conductrice inférieure (200) côte à côte dans le sens de la largeur de sorte que chacune parmi la couche conductrice supérieure (100) et la couche conductrice inférieure (200) est divisée en une pluralité de premières tranches (100a) et en une pluralité de secondes tranches (200a) ;
former (S300) une pluralité de régions de montage de DEL (120) en usinant la couche conductrice supérieure (100) de sorte que la surface supérieure de la couche conductrice inférieure (200) est exposée ;
monter (S400) une DEL (400) dans chacune des régions de montage de DEL (120) de sorte que l'énergie est fournie à la DEL (400) par la couche conductrice inférieure (200) et la couche conductrice supérieure (100) ;
charger chacune des régions de montage de DEL (120) avec une résine (500) ayant des propriétés d'isolation et une transparence (S500) ; et
former (S600) une couche isolante (110) sur toute la surface exposée de la couche conductrice supérieure (100) et de la couche conductrice inférieure (200).

5. Procédé pour fabriquer un module de réseau de DEL selon l'une quelconque des revendications 1 à 4, dans lequel chacune parmi la couche conductrice supérieure (100) et la couche conductrice inférieure (200) a une forme rectangulaire, et
les régions de montage de DEL sont disposées sur une rangée ou selon une forme de treillis de deux rangées ou plus.

6. Procédé pour fabriquer un module de réseau de DEL selon l'une quelconque des revendications 1 à 4, dans lequel chacune parmi la couche conductrice supérieure (100) et la couche conductrice inférieure (200) a une forme de disque, et
les régions de montage de DEL sont disposées radialement à partir du centre de la couche conductrice supérieure sous la forme d'au moins une rangée.

7. Procédé pour fabriquer un module de réseau de DEL selon l'une quelconque des revendications 1 à 4, dans lequel chacune parmi la couche conductrice supérieure (100) et la couche conductrice inférieure (200) est un film d'aluminium fin, un film de métal fin, un film de polyester conducteur fin ou un film de silicium fin.

8. Procédé pour fabriquer un module de réseau de DEL selon l'une quelconque des revendications 1 à 4, dans lequel chacune parmi la couche conductrice supérieure (100) et la couche conductrice inférieure (200) a une épaisseur de 0,5 - 2,5 mm.

9. Procédé pour fabriquer un module de réseau de DEL selon la revendication 1 ou 2, dans lequel la couche isolante (110) est un film d'oxyde de silicium, un film d'oxyde d'aluminium ou un film d'oxyde de chrome.

10. Procédé pour fabriquer un module de réseau de DEL selon l'une quelconque des revendications 1 à 4, dans lequel chacune des régions de montage de DEL (120) a une forme conique de tête coupée, et est prévue à l'intérieur de cette dernière avec une partie de raccordement de liaison de fil (121).

11. Module de réseau de DEL, **caractérisé en ce qu'**une couche conductrice supérieure (100) est fixée de manière solidaire à la couche conductrice inférieure (200) par une couche d'adhésion isolante (300) en tant que couche intermédiaire, et une couche isolante (110) est formée sur toute la surface exposée de la couche conductrice supérieure (100) et de la couche conductrice inférieure (200) ;
une pluralité de régions de montage de DEL (120) est formée dans la couche conductrice supérieure (100) de sorte que la surface supérieure de la couche conductrice inférieure (200) est exposée ;
une DEL (400) est montée dans chacune des régions de montage de DEL (120) de sorte que l'énergie est fournie à la DEL (400) par la couche conductrice inférieure (200) et la couche conductrice supérieure (100) et chacune des régions de montage de DEL (120) est chargée avec une résine (500) ayant des propriétés d'isolation et une transparence ; et
des rainures de séparations supérieures (130) sont formées dans la couche conductrice supérieure (100) à intervalles réguliers dans le sens de la largeur toutes les deux régions de montage de DEL, et des rainures de séparation inférieures (220) sont formées dans la couche conductrice inférieure (200) de sorte que chacune des rainures de séparation inférieures (220) est disposée entre les deux rainures de séparation supérieures (130).

12. Module de réseau de DEL selon la revendication 11,
dans lequel chacune parmi la couche conductrice supérieure (100) et la couche conductrice inférieure (200) a une forme rectangulaire, et
les régions de montage de DEL sont disposées selon une forme de treillis d'une ou de plusieurs rangées.

13. Module de réseau de DEL selon la revendication 11,
dans lequel chacune parmi la couche conductrice supérieure (100) et la couche conductrice inférieure (200) a une forme de disque, et
les régions de montage de DEL sont disposées de manière radiale à partir du centre de la couche conductrice supérieure sous la forme d'au moins une rangée.
